(19) Europäisches Patentamt
European Patent Office
Office européen des brevets

(11) **EP 3 875 975 B1**

(12) **EUROPÄISCHE PATENTSCHRIFT**

(45) Veröffentlichungstag und Bekanntmachung des Hinweises auf die Patenterteilung:
**14.09.2022   Patentblatt 2022/37**

(21) Anmeldenummer: **20160638.1**

(22) Anmeldetag: **03.03.2020**

(51) Internationale Patentklassifikation (IPC):
***G01R 31/389*** (2019.01)      ***G01R 31/396*** (2019.01)

(52) Gemeinsame Patentklassifikation (CPC):
**G01R 31/389; G01R 31/396**

(54) **VERFAHREN UND VORRICHTUNG ZUM LADUNGSTRANSFER FÜR DIE ELEKTROCHEMISCHE IMPEDANZSPEKTROSKOPIE**

METHOD AND DEVICE FOR LOAD TRANSFER FOR ELECTROCHEMICAL IMPEDANCE SPECTROSCOPY

PROCÉDÉ ET DISPOSITIF DE TRANSFERT DE CHARGE POUR LA SPECTROSCOPIE À IMPÉDANCE ÉLECTROCHIMIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**08.09.2021   Patentblatt 2021/36**

(73) Patentinhaber: **Safion GmbH**
**52068 Aachen (DE)**

(72) Erfinder:
• **Wienhausen, Arne Hendrik**
**52070 Aachen (DE)**
• **Zappen, Hendrik**
**53925 Kall (DE)**

(74) Vertreter: **Raffay & Fleck**
**Patentanwälte**
**Grosse Bleichen 8**
**20354 Hamburg (DE)**

(56) Entgegenhaltungen:
| | |
|---|---|
| **US-A1- 2011 295 533** | **US-A1- 2012 019 253** |
| **US-A1- 2013 099 747** | **US-A1- 2015 145 520** |
| **US-A1- 2017 003 355** | **US-A1- 2017 144 565** |
| **US-A1- 2019 113 577** | |

• **LOCOROTONDO EDOARDO ET AL: "Electrochemical Impedance Spectroscopy of Li-Ion battery on-board the Electric Vehicles based on Fast nonparametric identification method", 2019 IEEE INTERNATIONAL CONFERENCE ON ENVIRONMENT AND ELECTRICAL ENGINEERING AND 2019 IEEE INDUSTRIAL AND COMMERCIAL POWER SYSTEMS EUROPE (EEEIC / I&CPS EUROPE), IEEE, 11. Juni 2019 (2019-06-11), Seiten 1-6, XP033587352, DOI: 10.1109/EEEIC.2019.8783625 [gefunden am 2019-07-31]**
• **ERIC DIN ET AL: "A Scalable Active Battery Management System With Embedded Real-Time Electrochemical Impedance Spectroscopy", IEEE TRANSACTIONS ON POWER ELECTRONICS, Bd. 32, Nr. 7, 8. September 2016 (2016-09-08), Seiten 5688-5698, XP055564977, USA ISSN: 0885-8993, DOI: 10.1109/TPEL.2016.2607519**

**Beschreibung**

Aus dem Stand der Technik ist es bekannt, Batterien mit mehreren Zellen, einem Balancing zu unterziehen, bekannt ist hier ein passives und ein aktives Balancing. Aktives Balancing wird jeweils zwischen benachbarten Zellen oder Zellengruppen oder mittels eines Busses über unbeteiligte Zellen hinweg durchgeführt. Aktives Balancing ist jedoch mit vergleichsweise großem apparativem Aufwand verbunden, da jede Zelle eine entsprechende Beschaltung zum Ladungstransfer aufweisen muss.

Aus der US 2017 163,160 A1 und der US 1,0393,818 B2 sowie "A Scalable Active Battery Management System with Embedded Real-Time Electrochemical Impedance Spectroscopy", Din et. al., DOI 10.1109/TPEL.2016.2607519, IEEE Transactions on Power Electronics ist es bekannt unter Nutzung einer Anordnung für das aktive Balancing, Ladung zwischen zwei benachbarten Zellen zu transferieren und dies zur elektrochemischen Impedanzspektroskopie (EIS) zu nutzen. Die US 2019 0288520 A1 offenbart das Auftrennen einer Batterie in zwei oder mehr Module und die Verwendung eines dieser Module als Spannungsversorgung für ein Balancing oder einen Test eines andern dieser Module.

Die US 2015/145520 A1 offenbart ein Verfahren zum Bewerten von Zellen in einer Batterie, wobei ein Impedanzwert einer Zelle auf der Grundlage eines demodulierten Stroms und einer demodulierten Spannung ermittelt wird.

Auch ist es bekannt zur Erzeugung einer Anregung Energie aus einer Batterie oder Zelle zu entnehmen und in einem zellen- und batterieexternen Speicher, insbesondere einem Speicherkondensator und/oder einer Speicherinduktivität, zwischen zu speichern und sodann zumindest teilweise in die Zelle oder Batterie zu transferieren. Dies wird in der Regel periodisch durchgeführt, um so ein Wechselstrom in der Batterie und/oder Zelle zu erzeugen. Dazu wird ein Speicher vorgesehen, der so dimensioniert ist, dass er mindestens die Energiemenge des größten Anregungssignals, ggf. abzüglich oder zuzüglich etwa der beim Ladungstransfer zwischen Akkumulator und Energiespeicher auftretenden Verluste speichern kann. Dies ist insbesondere bei großen Batterien und niedrigen Frequenzen des Anregungssignals problematisch.

Aufgabe ist es, ein System und ein Verfahren anzugeben, mit dem EIS Messungen, insbesondere an Einzelzellen, mit deutlich weniger apparativem Aufwand an einer Batterie durchgeführt werden können und dies mit möglichst wenig Energieverlust und auch bei Batterien mit hoher Kapazität und auch bei niedrigen Anregungsfrequenzen.

Gelöst wird die Aufgabe durch ein Verfahren laut dem Anspruch 1 und eine Vorrichtung laut dem Anspruch 9 wie nachfolgend beschrieben:
Ein erfindungsgemäßes Verfahren ist ein Verfahren zur Bestimmung mindestens eines Impedanzwertes, insbesondere einer Vielzahl von Impedanzwerten, mindestens einer, insbesondere aller, Akkumulatorzelle(n) einer ersten Menge von Akkumulatorzellen.

Das Verfahren betrifft eine erste Menge von Akkumulatorzellen, wobei die erste Menge von Akkumulatorzellen durch eine erste Anzahl von Akkumulatorzellen und eine zweite Anzahl von Akkumulatorzellen gebildet wird.

Erfindungsgemäß wird mindestens ein Spannungswert, insbesondere mindestens eine Spannung und/oder Spannungsveränderung, mindestens einer der Akkumulatorzellen der ersten und/oder zweiten Anzahl bestimmt.

Erfindungsgemäß sind die Akkumulatorzellen der ersten Anzahl in Reihe mit den Akkumulatorzellen der zweiten Anzahl geschaltet, wobei die erste und die zweite Anzahl jeweils mindestens zwei, insbesondere jeweils mindestens sechs beträgt und wobei die erste Anzahl Akkumulatorzellen mindestens zwei, insbesondere mindestens sechs, in Reihe geschaltete Akkumulatorzellen aufweist und wobei die zweite Anzahl Akkumulatorzellen mindestens zwei, insbesondere mindestens sechs, in Reihe geschaltete Akkumulatorzellen aufweist, dadurch gekennzeichnet, dass während der Bestimmung des mindestens einen Spannungswertes, insbesondere periodisch, Ladung zwischen der ersten Anzahl von Akkumulatorzellen und der zweiten Anzahl von Akkumulatorzellen hin und her transferiert wird.

Gelöst wird die Aufgabe auch durch die Verwendung einer, insbesondere periodischen, Ladungsverschiebung zwischen einer ersten Anzahl Akkumulatorzellen und einer zweiten Anzahl Akkumulatorzellen, wobei die erste Anzahl Akkumulatorzellen und die zweite Anzahl Akkumulatorzellen eine erste Menge von Akkumulatorzellen bilden. Bevorzugt erfolgt der Ladungstransfer während der Ladung oder Entladung der, insbesondere aller der, ersten Menge der Akkumulatorzellen.

Erfindungsgemäß sind die Akkumulatorzellen der ersten Anzahl in Reihe mit den Akkumulatorzellen der zweiten Anzahl geschaltet sind, wobei die erste und die zweite Anzahl jeweils mindestens zwei, insbesondere mindestens sechs beträgt und wobei die erste Anzahl Akkumulatorzellen mindestens zwei, insbesondere mindestens sechs in Reihe geschaltete Akkumulatorzellen aufweist und wobei die zweite Anzahl Akkumulatorzellen mindestens zwei in Reihe geschaltete Akkumulatorzellen aufweist.

Erfindungsgemäß wird weiter mindestens ein Spannungswert, insbesondere mindestsens eine Spannung und/oder Spannungsveränderung, mindestens einer der Akkumulatorzellen der ersten und/oder mindestens ein Spannungswert, insbesondere mindestsens eine Spannung und/oder Spannungsveränderung, mindestens einer der zweiten Anzahl bestimmt.

Dies erfolgt insbesondere zur Bestimmung mindestens eines Impedanzwertes, insbesondere einer Vielzahl von Impedanzwerten mindestens einer, insbesondere aller, Akkumulatorzelle der ersten Menge von Akkumulatorzellen.

Gelöst wird die Aufgabe auch durch eine Vorrichtung, insbesondere zur Durchführung mindestens einer Impedanzmessung, insbesondere elektrochemischen Impedanzspektroskopie, eingerichtet insbesondere zur Bestimmung mindestens eines Impedanzwertes, insbesondere einer Vielzahl von Impedanzwerten, mindestens einer Akkumulatorzelle einer ersten Menge von Akkumulatorzellen. Insbesondere ist die Vorrichtung für eine solche Anordnung von Akkumulatorzellen der ersten Menge geeignet und/oder eingerichtet, bei der die erste Menge von Akkumulatorzellen durch eine erste Anzahl von Akkumulatorzellen und eine zweite Menge von Akkumulatorzellen gebildet wird, wobei die Akkumulatorzellen der ersten Anzahl in Reihe mit den Akkumulatorzellen der zweiten Anzahl geschaltet sind und wobei die erste und die zweite Anzahl jeweils mindestens zwei, insbesondere jeweils mindestens sechs, beträgt und wobei die erste Anzahl Akkumulatorzellen mindestens zwei, insbesondere mindestens sechs, in Reihe geschaltete Akkumulatorzellen aufweist und wobei die zweite Anzahl Akkumulatorzellen mindestens zwei, insbesondere mindestens sechs, in Reihe geschaltete Akkumulatorzellen aufweist.

Die Vorrichtung ist des Weiteren eingerichtet, mindestens einen Spannungswert, insbesondere mindestsens eine Spannung und/oder Spannungsveränderung, mindestens einer der Akkumulatorzellen der ersten oder der zweiten Anzahl zu bestimmen, wobei die Vorrichtung weiter eingerichtet ist während der Bestimmung des mindestens einen Spannungswertetes, insbesondere periodisch, Ladung zwischen der ersten Anzahl von Akkumulatorzellen und der zweiten Anzahl von Akkumulatorzellen hin und her zu transferieren.

Gelöst wird die Aufgabe auch durch ein Ladegerät für einen Akkumulator mit einer ersten Menge Akkumulatorzellen, wobei das Ladegerät eine erfindungsgemäße Vorrichtung aufweist und insbesondere eingerichtet ist, während der Ladung des Akkumulators, insbesondere aller Zellen der ersten Menge, den mindestens einen Impedanzwert zu bestimmen und/oder ein erfindungsgemäßes Verfahren durchzuführen.

Gelöst wird die Aufgabe auch durch ein Batteriemanagementsystem, insbesondere eingerichtet zum Entladen, insbesondere zur Nutzung der Energie der Entladung, und/oder Laden eines Akkumulators mit einer ersten Menge Akkumulatorzellen, wobei die Akkumulator Steuerung eine erfindungsgemäße Vorrichtung und/oder ein Ladegerät aufweist und insbesondere eingerichtet ist, den mindestens einen Spannungswert während des Ladens und/oder Entladens des Akkumulators, insbesondere aller Akkumulatorzellen der ersten Menge, mittels des Batteriemanagementsystems zu bestimmen.

Gelöst wird die Aufgabe auch durch einen Akkumulator aufweisend eine erste Menge Akkumulatorzellen und mindestens eine Batteriemanagementsystem und/oder Ladegerät und/oder eine erfindungsgemäße Vorrichtung.

Die Bestimmung des mindestens einen Spannungswertes erfolgt insbesondere kontinuierlich, sodass als mindestens ein Spannungswert ein Spannungsverlauf bestimmt wird. Ein solcher Spannungsverlauf wird insbesondere für mehrere Ackumulatorzellen separat bestimmt. Dies erfolgt insbesondere stromlos, mittels einer Vierpunktmessung und/oder an der Anode und Kathode der jeweiligen Zelle. Neben oder anstelle der Bestimmung mindestens eines Spannungswertes mindestens einer Einzelzelle oder einer Parallelschaltung von Einzelzellen kann auch die Gesamtspannung der Zellen der ersten und/oder zweiten Anzahl bestimmt werden.

Als Spannungswert kann die absolute Spannung und/oder die Änderung der Spannung bestimmt werden. Insbesondere wird, zumindest indirekt die Spannungsänderung während des Ladungstransfers bestimmt.

Der mindestens eine Spannungswert wird insbesondere so bestimmt, dass dazu genutzte Leiter und/oder insbesondere die zum Ladungstransfer und zur Bestimmung des mindestens einen Spannungswerts gemeinsam verwendeten Leiter oder Leiterabschnitte eine Impedanz von weniger als 3% der Impedanz der Akkumulatorzellen der ersten Menge aufweisen, insbesondere bei jeder Frequenz, die Bestandteil des Anregungssignal oder Teil des Ladungstransfers ist, insbesondere jeder Frequenz. Bevorzugt wird es jedoch, keine Leiterabschnitte gemeinsam für die Bestimmung des mindestens einen Spannungswertes und für den Ladungstransfer zu nutzen. Es spricht jedoch nichts dagegen zur Spannungsmessung einer ersten und einer zweiten an die elektrisch angrenzende Zelle einen gemeinsamen Leiter zu verwenden. So können dafür beispielsweise auch Sense- oder Balancingleitungen oder -ports des Akkumulators verwendet werden. Für den Ladungstransfer wird insbesondere der Plus und der Minuspol des Akkumulators und oder der Anfangs- und der Endpunkt der Reihenschaltung der ersten und zweiten Anzahl sowie ein zusätzlicher Leiter, der zwischen der ersten und zweiten Anzahl in deren Reihenschaltung angreift, verwendet.

Aus dem mindestens einen Spannungswert und mindestens einem Strom des Ladungstransfers, lässt sich die mindestens eine Impedanz bestimmen. Insbesondere wird ein Impedanzspektrum bestimmt, dazu wird insbesondere eine Vielzahl von Frequenzanteilen für den Ladungstransfer genutzt und eine Vielzahl von Spannungswerten je betrachteter Akkumulatorzelle bestimmt. Anstelle oder zusätzlich zu der Bestimmung von Einzelzellenimpedanzen oder -impedanzspektren kann auch eine Impedanz oder ein Impedanzspektrum der ersten und/oder der zweiten Anzahl bestimmt werden.

Durch die Erfindung kann eine Anregung der Akkumulatorzellen mittels der Ladungsverschiebung erreicht werden, insbesondere ohne Energie außerhalb der ersten Menge Akkumulatorzellen zwischenspeichern zu müssen. Dies vereinfacht den Aufbau und reduziert den Energieverlust. Zudem kann durch die Erfindung auch die Gesamtspannung der ersten Menge der Akkumulatorzellen und somit insbesondere eines Akkumulators während der Ladungsverschiebung konstant gehalten werden, da beispielsweise die Entladung der ersten Anzahl durch die zeitgleiche Ladung der zweiten Anzahl ausgeglichen wird.

Der Ladungstransfer kann dabei wie in bekannten EIS-Verfahren gewählt werden, wobei unproblematisch größere Ströme und niedrigere Frequenzen realisierbar sind, als im Stand der Technik möglich und dies bei geringem apparativem Aufwand. Grundsätzlich reicht ein DC/DC Wandler aus, um die Ladung zwischen der ersten Anzahl und er zweiten Anzahl zu verschieben. Zumindest ist nicht jedem Zellenpaar ein Spannungswandler beizustellen. Vorteilhafterweise wird der Ladungstransfer so bewirkt, dass der Transferstrom, mit dem die Ladung verschoben wird und/oder der Strom durch die erste Anzahl der Akkumulatorzellen und/oder der Strom durch die zweite Anzahl von Akkumulatorzellen eine Vielzahl von Frequenz und/oder eine Vielzahl von unterschiedlichen Phasenlagen, insbesondere von sinusförmigen Signalanteilen, aufweist.

Der periodische Ladungstransfer muss nicht bei jeder der verwendeten Frequenzen periodisch ausgebildet sein, wenn das Verfahren vor Erreichen der Periodizität, also beispielsweise nach einer halben Periode abgebrochen oder geändert wird. So kann beispielsweise bei kurzer Verfahrensführung bei niedrigen Frequenzen nur eine Halbwelle durchfahren werden. Bevorzugt ist der Ladungstransfer aber in allen Frequenzanteilen periodisch.

Besonders bevorzugt wird der Ladungstransfer mittels Synchrongleichrichtung bewirkt und/oder weist die Vorrichtung mindestens einen Synchrongleichrichter auf.

Insbesondere wird, zumindest überwiegend, der Tastgrad eines Schalters, insbesondere eines oder des High-side-Schalters, des Spannungswandlers zwischen $d_{1,min}$ und $d_{1,max}$ gewählt, mit:

$$d_{1,\text{min}} = \begin{cases} \dfrac{V_{\text{Bat}-}}{V_{\text{Bat}+} + V_{\text{Bat}-}} - 0,2 & ,\text{für } \dfrac{V_{\text{Bat}-}}{V_{\text{Bat}+} + V_{\text{Bat}-}} > 0,3 \\[4mm] 0,1 & ,\text{für } \dfrac{V_{\text{Bat}-}}{V_{\text{Bat}+} + V_{\text{Bat}-}} \le 0,3 \end{cases}$$

$$d_{1,\text{max}} = \begin{cases} \dfrac{V_{\text{Bat}-}}{V_{\text{Bat}+} + V_{\text{Bat}-}} + 0,2 & ,\text{für } \dfrac{V_{\text{Bat}-}}{V_{\text{Bat}+} + V_{\text{Bat}-}} < 0,7 \\[4mm] 0,9 & ,\text{für } \dfrac{V_{\text{Bat}-}}{V_{\text{Bat}+} + V_{\text{Bat}-}} \ge 0,7 \end{cases}$$

Dabei sind $V_{Bat+}$ die Gesamtspannung der ersten Anzahl Akkumulatorzellen und $V_{Bat-}$ die Gesamtspannung der zweiten Anzahl Akkumulatorzellen und sind $d_{1,min}$ und $d_{1,max}$ die Grenzen des Tastgrads eines ersten Schalters S1 des Spannungswandlers (also z.B. des High-Side-Transistors) bzw. des entsprechenden PWM-Signals (PWM1) zur Ansteuerung des Schalters. Ein zweiter Schalter des Spannungswandlers (also z.B. des Low-Side-Transistors) wird insbesondere komplementär zum ersten geschaltet (mit einer kurzen Totzeit, in der beide Schalter aus sind, um einen Kurzschluss durch die Halbbrücke zu verhindern). Es gilt also insbesondere

$$d_1 + d_2 + \text{Totzeit1}/T_{\text{PWM}} + \text{Totzeit2}/T_{\text{PWM}} = 1$$

mit $d_2$ Tastgrad des zweiten Schaltelements, $d_1$ Tastgrad des ersten Schaltelements und $T_{PWM}$ der Periodendauer des PWM-Signals. Die Totzeit1 und die Totzeit2 zusammen betragen insbesondere weniger als 10% der Schaltperiode.

Insbesondere werden Filterkondensatoren und/oder Filterdrosseln zur Glättung der durch die Schaltvorgänge im Spannungswandler verursachten Artefakte verwendet. Filterkondensatoren und/oder Filterdrosseln sollten so gewählt werden, dass der Stromrippel bei maximaler Amplitude des Ladungstransferstroms, insbesondere bei dem maximalen Ladungstransferstrom, für den die Vorrichtung ausgelegt ist, 30%, insbesondere 20%, des maximalen Stroms und/oder der Spannungsrippel 20%, insbesondere 10%, der Gesamtspannung der ersten Menge der Akkumulatorzellen nicht übersteigen.

Insbesondere ist der mindestens eine Spannungswert eine durch den Ladungstransfer bewirkte Spannungsveränderung. Insbesondere wird der Strom, insbesondere der den Ladungstransfer bewirkende Strom, durch die Akkumulatorzellen der ersten Anzahl und/oder der Strom durch die Akkumulatorzellen der zweiten Anzahl bestimmt, insbesondere gemessen. Insbesondere wird der mindestens eine Spannungswert und/oder mindestens ein bestimmter Strom zur Bestimmung des mindestens einen Impedanzwertes verwendet. Insbesondere bei bekanntem und/oder konstantem Strom, ist es nicht notwendig die Impedanz zu bestimmen, es kann vielmehr auch ausreichen, eine Folge von Spannungswerten in den Frequenzbereich transformiert, die insbesondere einen komplexen Spannungszeiger bilden, zu betrachten, weil dieser dann direkt mit der Impedanz verknüpft ist und sozusagen einen Impedanzwert darstellt.

Besonders bevorzugt sind die Akkumulatorzellen der ersten Anzahl, insbesondere unmittelbar aufeinander folgend, in Reihe geschaltet und/oder die Akkumulatorzellen der zweiten Anzahl, insbesondere unmittelbar aufeinander folgend, in Reihe geschaltet und/oder die Akkumulatorzellen der ersten Anzahl, insbesondere unmittelbar aufeinander folgend, in Reihe mit den Akkumulatorzellen der zweiten Anzahl geschaltet sind und/oder die Akkumulatorzellen der ersten Menge in Reihe geschaltet sind. Es ist aber beispielsweise auch denkbar, dass die erste Menge und/oder die zweite Menge je eine gemischte Reihen- und Parallelschaltung ausbildet. So können mehrere Gruppen untereinander parallel geschalteter Zellen zu Reihen geschaltet sein. In der Regel wird dann keine Einzelzellenimpedanz bestimmt, sondern die Impedanz der parallelgeschalteten Zellen einer Gruppe.

Bevorzugt sind die Akkumulatorzellen der ersten Menge Akkumulatorzellen eines einzigen Akkumulators, wobei der Akkumulator insbesondere keine weiteren Ackumulatorzellen aufweist.

Insbesondere ist die erste Anzahl 50 bis 150%, insbesondere 80 - 120%, insbesondere gleich, der zweiten Anzahlen und/oder ist die Gesamtkapazität, insbesondere tatsächlichen Gesamtkapazität oder Nenngesamtkapazität, der Akkumulatorzellen der ersten Anzahl im Bereich von 80 bis 120% der Gesamtkapazität, insbesondere tatsächlichen Gesamtkapazität oder Nenngesamtkapazität, der Ackumulatorzellen der zweiten Anzahl. Dadurch lässt sich das Verfahren besonderes energieeffizient führen.

Besonders bevorzugt liegt die erste und/oder zweite Anzahl jeweils im Bereich von 4 oder größer, insbesondere bis 50, insbesondere im Bereich von 4 bis 30 und/oder die erste und/oder die weiteren Mengen jeweils im Bereich von 8 bis 100, insbesondere im Bereich von 10 bis 60.

Insbesondere sind die Akkumulatorzellen der ersten Anzahl und der zweiten Anzahl disjunkt und/oder sind die Akkumulatorzellen der ersten Menge und jeder der weiteren Menge disjunkt.

Besonders bevorzugt umfasst die erste Menge oder umfassen die erste Menge und die mindestens eine weitere Menge alle Akkumulatorzellen des Akkumulators.

Vorteilhafterweise handelt es sich bei den Akkumulatorzellen um Lithium-Ionen-Akkumulatorzellen, beispielsweise Lithium-Cobaltdioxid-Akkumulatorzellen, Lithium-Nickel-Mangan-Cobalt-Akkumulatorzellen, Lithium-Nickel-Cobalt-Aluminium-Akkumulatorzellen, Lithium-Mangan-Akkumulatorzellen, Lithium-Eisenphosphat-Akkumulatorzellen und/oder Lithiumtitanat-Akkumulatorzellen, insbesondere als Lithium-Polymer-Akkumulatorzellen.

Bevorzugt wird der Ladungstransfer, insbesondere abwechselnd, durch

- teilweises Entladen der Akkumulatorzellen der ersten Anzahl und Laden der Akkumulatorzellen der zweiten Anzahl und
- teilweises Entladen der Akkumulatorzellen der zweiten Anzahl und Laden der Akkumulatorzellen der ersten Anzahl

durchgeführt.

In speziellen Ausgestaltungen, insbesondere bei Verbindung mit einem Stromnetz oder einer Stromquelle mit nicht benötigter Leistung, wird insbesondere die entladene Leistung zur Ladung genutzt und besonders bevorzugt die Verlustleistung des Ladungstransfers durch Einbringen externer Energie, insbesondere aus dem Stromnetz oder der nicht benötigten Leistung, ausgeglichen.

Insbesondere wird die die Ladung und Entladung mittels mindestens eines DC/DC-Wandlers, insbesondere galvanisch gekoppelte oder galvanisch getrennt, durchgeführt. Galvanisch gekoppelte Wandler werden jedoch bevorzugt.

Insbesondere wird der Ladungstransfer, insbesondere periodisch, bewirkt und reversiert, insbesondere mit mindestens einer Frequenz, insbesondere im Bereich zwischen 0,1 und 10 kHz und/oder mit mindestens einer Frequenz von 1kHz oder weniger.

Insbesondere weisen die Frequenzanteile des Ladungstransfers unter 1kHz einen Ladungstransfer-Gesamtstrom von mindestens 0,1 A auf, insbesondere bei Nenngesamtspannung der Akkumulatorzellen der ersten Menge von 12V und weniger und/der einer ersten Menge von weniger als 20 Akkumulatorzellen.

Besonders bevorzugt, weisen die Frequenzanteile des Ladungstransfers unter 1kHz einen Ladungstransfer-Gesamtstrom, insbesondere bei einer Nenngesamtspannung der Akkumulatorzellen der ersten Menge von mehr als 12V und/der einer ersten Menge von mehr als 20 Akkumulatorzellen von mindestens 1A, bevorzugt mindestens 2 A, besonders bevorzugt von mindestens 3 A auf.

Insbesondere werden der Ladungstransfer und der reversierte Ladungstransfer so durchgeführt wird, dass im Zeitmittel über Vielfache der Periode der kleinsten enthaltenen Frequenz Nettoladungsverschiebung von weniger als 1 % der Nennkapazität der ersten Menge zwischen der ersten Anzahl Akkumulatorzellen und zweiten Anzahl Akkumulatorzellen stattfindet.

In einer besonderen Ausführung können der Ladungstransfer und der reversierte Ladungstransfer so durchgeführt werden, dass ein Balancing zwischen den Akkumulatorzellen der ersten Anzahl und der zweiten Anzahl bewirkt wird, insbesondere durch Aufprägen eines Gleichstroms auf das Ladungstransfersignal.

Insbesondere werden der Ladungstransfer und der reversierte Ladungstransfer so durchgeführt, dass die Gesamtspannung der ersten Menge, der Mengen und/oder des Akkumulators weniger als 2% schwankt, wobei insbesondere die Amplitude der Spanungsschwankung mindestens einer der Akkumulatorzellen der ersten Menge mindestens 1mV beträgt.

Mit Vorteil wird jeweils mindestens ein Spannungswert einer Vielzahl, insbesondere jeder, Akkumulatorzelle(n) der ersten und/oder der zweiten Anzahl und/oder mindestens jeweils ein Gesamtspannungswert der ersten Anzahl von Akkumulatorzellen und/oder der zweiten Anzahl von Akkumulatorzellen gemessen. Dadurch lässt sich mit einem Anregungssignal eine Aussage über eine Vielzahl von Zellen machen.

Der mindestens eine Spannungswert oder jeder der mindestens einen Spannungswerte ist insbesondere eine Menge aufeinanderfolgender Spannungswerte und/oder ein Spannungsverlauf, insbesondere mit einem Abstand von Einzelspannungsmessungen von weniger als 100ms.

Die Spannungswerte, insbesondere jeweils die Menge aufeinanderfolgender Spannungswerte an den gleichen Messpunkten und/oder der und/oder den Akkumulatorzelle(n) wird bevorzugt einer Fouriertransformation unterzogen, insbesondere um die mindestens eine Impedanz zu ermitteln.

In einer möglichen Ausgestaltung kann das Verfahren mit mindestens einer weiteren Menge von Akkumulatorzellen, insbesondere wie mit der ersten Menge, durchgeführt wird, insbesondere zeitgleich, wobei alle Akkumulatorzellen der ersten und der weiteren Menge in Reihe geschaltet sind, insbesondere unmittelbar aufeinanderfolgend oder parallelgeschaltet sind.

Vorteilhafterweise sind die Akkumulatorzellen der ersten Menge und/oder die Ackumulatorzellen der ersten und der mindesten einen weiteren Menge in einer gemeinsamen Hausung angeordnet. Vorteilhafterweise umfasst diese Hausung, insbesondere nur, die Akkumulatorzellen mit ihren Ummantelungen und optional eine erfindungsgemäße Vorrichtung, beispielsweise ein Batteriemanagementsystem und/oder keine weiteren aktiven Bauteile.

Mit Vorteil erfolgt die Spannungsmessung und/oder der Ladungstransfer mittels mindestens eines Balancinganschlusses und/oder mindestens einer Sense-Leitung des Akkumulators. Dabei ist insbesondere zu beachten, dass vorteilhafterweise gemeinsam für Spannungsmessung und Ladungstransfer genutzte Leiterabschnitte den genannten Anforderungen entsprechen, insbesondere ganz vermieden werden.

Mit Vorteil wird das Verfahren so betrieben, dass im zeitlichen Mittel, betrachtet insbesondere über eine Zeitspanne von ganzzahligen Vielfachen der Periodendauer der kleinsten enthaltenen Frequenz, ein Nettoladungstransfer, insbesondere zwischen erster und zweiter Anzahl, von weniger als 1 % der Nennkapazität des Akkumulators, insbesondere pro Stunde, insbesondere kein netto Ladungstransfer zwischen den Akkumulatorzellen der ersten Anzahl und der zweiten Anzahl erfolgt.

Ein besonderer Vorteil des Verfahrens ist es, dass der Ladungstransfer und/oder die Bestimmung des mindesten einen Spannungswerts während des Ladens oder Entladens, insbesondere zur Nutzung der Energie, des Akkumulators, insbesondere aller seiner Akkumulatorzellen, erfolgen kann und insbesondere erfolgt, ohne größere Nachteile in Kauf zu nehmen.

Dies ermöglicht die, insbesondere kontinuierliche, Nutzung der Erfindung während der normalen und insbesondere nicht unterbrochenen Nutzung der ersten und/oder der weiteren Mengen der Akkumulatorzellen. Da zudem die Verlustleistung bei kontinuierlicher Messung unter 1 % der Nennenergie pro Stunde liegen kann und auch die benötigte elektrische Leistung für die Steuerung des Ladungstransfers und der Spannungsmessung und der Auswertung unter 30 W gehalten werden kann, ist eine autarke und kontinuierliche Überwachung während der Nutzung möglich.

Mit besonderem Vorteil weist der Ladungstransferstrom und/oder das Anregungssignal Anteile mit unterschiedlicher Phasenlage und/oder unterschiedlichen Frequenzen auf. Mit Vorteil wird die, insbesondere durch den Ladungstransfer bewirkte und/oder periodisch und/oder durch das Verfahren, in einem Energiespeicher außerhalb des Akkumulators und/oder der Akkumulatorzellen der ersten Menge und/oder der ersten Menge und den weiteren Mengen, insbesondere in einen Kondensator, gespeicherte Energiemenge geringer gehalten als

$$\hat{\imath}_{\mathrm{f}} \cdot (U_{\mathrm{Leerlauf}} + \hat{u}_f)$$

$$2 \cdot f_{\mathrm{min}}$$

Dabei ist $\hat{\imath}_{\mathrm{f}}$ die maximale Amplitude des Anregungssignals oder des Ladungstransferstroms (gemessen in Ampere), $U_{\mathrm{Leerlauf}}$ die Nenngesamt- oder Leerlaufgesamtspannung der ersten Menge von Akkumulatorzellen (gemessen in Volt), und $\hat{u}_f$ die maximale Amplitude der Summe der Einzelspannungsantwort der Akkumulatorzellen der ersten Menge und/oder der ersten Menge und den weiteren Mengen (gemessen in Volt).

Es wird insbesondere Energie nur durch die Filterung und/oder durch die Spannungswandler zwischengespeichert, dies erfolgt insbesondere im Zeithorizont und/oder maximal über Zeiträume der Dauer zwischen Umschaltungen der Schaltelemente der Spannungswandler und/oder über deutlich kürzere Zeiträume als die Perioden der, insbesondere aller, Frequenzanteile des Ladungstransferstroms, insbesondere zwischen erster und zweiter Anzahl von Akkumulatorzellen, insbesondere nur über Zeiträume von maximal 1/10, insbesondere maximal 1/50, der Periode der niedrigsten Frequenz des Ladungstransferstroms, insbesondere zwischen erster und zweiter Anzahl von Akkumulatorzellen, und/oder des Anregungssignals. Dazu wird vorteilhafterweise der Filterkondensator und/oder Filter bis zu einer mittleren Spannung, insbesondere der, insbesondere mittleren, Gesamtspannung der ersten Menge und/oder ersten und/oder zweiten Anzahl Akkumulatorzellen aufgeladen. Insbesondere speichert der mindestens eine Filterkondensator und/oder Filter über lange Zeiten, insbesondere über die gesamte Dauer des Verfahren eine konstante Grundenergie, die sich insbesondere dadurch ergibt, dass er auf die, insbesondere mittlere Gesamtspannung der ersten Menge und/oder ersten und/oder zweiten Anzahl Akkumulatorzellen aufgeladen wird. Die Betrachtung der Dauer der Zwischenspeicherung bezieht sich dann insbesondere nur auf die Differenz zu dieser Grundenergie.

Insbesondere weist die Vorrichtung und/oder verwendet das Verfahren, insbesondere zum Ladungstransfer zwischen erster und zweiter Anzahl der Akkumulatorzellen, pro erster oder erster und weiter Menge, insbesondere absolut, maximal eine Gruppe von parallel geschalteten Spannungswandlern, insbesondere weniger Spannungswandler als Anzahl der Zellen des Akkumulators, insbesondere der ersten Menge, insbesondere der ersten Anzahl, abzüglich eins, insbesondere abzüglich zwei, insbesondere abzüglich zehn (auf).

Insbesondere weist die Vorrichtung und/oder verwendet das Verfahren, insbesondere zum Ladungstransfer zwischen erster und zweiter Anzahl der Akkumulatorzellen, keine in Reihe geschalten Spannungswandler (auf).

Insbesondere weist die Vorrichtung und/oder verwendet das Verfahren zum Ladungstransfer, insbesondere zwischen erster und zweiter Anzahl der Akkumulatorzellen, keine so in Reihe geschalten Spannungswandler (auf), dass der Ladungstransferstrom hintereinander durch mehr als einen Spannungswandler fließt.

Die Leistung des Anregungssignals oder Ladungstransferstroms lässt sich insbesondere allgemein so ausdrücken:

$$s_{scaled}(t) = r_{scale} \cdot \sum_{k=1}^{N} a_k \cdot \sin\left(2\pi f_k t + \phi_k\right)$$

mit $\Sigma a_k = 1$.

Vorteilhafterweise wählt man $r_{scale}$ so, dass die folgenden Bedingungen für den Scheitelwert $i_{peak}$ des Anregungssignals oder Ladungstransferstroms erfüllt sind:

- der Scheitelwert $i_{peak}$ der Stromanregung oder des Ladungstransferstroms ist so gewählt, dass die maximale Spannungsantwortamplitude einer Akkumulatorzelle einen Wert von höchstens 20 mV aufweist und/oder
- das Anregungssignal oder der Ladungstransferstrom weist im Falle mehrerer gleichzeitig angeregter Frequenzen einen Scheitelfaktor oder Crest-Faktor von 2,6 oder geringer auf und/oder
- das Anregungssignal oder der Ladungstransferstrom weist eine Effektivleistung größer als

$$k^2 = \frac{i_{peak}^2}{i_{rms}^2} = \frac{i_{peak}^2}{p_{rms}} \Rightarrow p_{rms} = \frac{i_{peak}^2}{k^2} \Rightarrow p_{rms} \geq \frac{i_{peak}^2}{2.6^2}$$

auf.

Mit besonderem Vorteil weisen die Vorrichtung, das Ladegerät und/oder das Batteriemanagementsystem eine Steuervorrichtung eingerichtet zur Durchführung des erfindungsgemäßen Verfahrens mittels der Vorrichtung, des Ladegeräts und/oder des Batteriemanagementsystems auf.

Mit besonderem Vorteil ist die Vorrichtung so ausgebildet, dass sie zum Zwischenspeichern von Energie, insbesondere aus einer Messung, keine Energiespeicher, insbesondere Kondensatoren und Spulen, aufweist, die eine Gesamtenergiespeicherkapazität von mehr als

$$\frac{u_{\max} \cdot i_{\max}}{4 \cdot f_{\min}}$$

aufweisen, wobei $u_{\max}$ die maximale Akkumulatorspannung oder maximale Gesamtspannung der Akkumulatorzellen der ersten Menge ist, für die die Vorrichtung eingerichtet ist und $i_{\max}$ die maximale Ladungstransferstromstärke ist, für die die Vorrichtung eingerichtet ist und $f_{\min}$ die minimale Ladungstransferfrequenz oder der minimale Frequenzanteil im Ladungstransferstrom ist, für die die Vorrichtung eingerichtet ist.

Mit besonderem Vorteil weist das Ladegerät einen Balancer und Balancerports zum Anschluss an Balancinganschlüsse oder Sense-Leitungen des Akkumulators auf und ist insbesondere eingerichtet, die Bestimmung der mindestens einen Spannung unter Verwendung mindestens eines Balancingports, Balancinganschluss oder mindestens einer Sense-Leitungen durchzuführen.

Mit Vorteil ist das Batteriemanagementsystem, insbesondere eingerichtet zum Entladen, insbesondere zur Nutzung der Energie der Entladung, und/oder Laden eines Akkumulators mit einer ersten Menge Akkumulatorzellen, wobei das Batteriemanagementsystem eine erfindungsgemäße Vorrichtung aufweist und insbesondere eingerichtet ist, den mindestens einen Spannungswert während des Ladens und/oder Entladens des Akkumulators mittels des Batteriemanagementsystems zu bestimmen.

Insbesondere wird das Verfahren mittels einer erfindungsgemäßen Vorrichtung, einem Akkumulator, Ladegerät und/oder Batteriemanagementsystem durchgeführt.

Weitere Vorteile und mögliche Ausgestaltungen sollen rein exemplarisch an den Folgenden rein schematischen Figuren erfolgen. Dabei zeigt:

Fig. 1: eine Darstellung einer EIS-Anordnung aus dem Stand der Technik

Fig. 2 eine vereinfachte schematische Darstellung der Schaltung für die Erzeugung des Ladungstransfers nach der vorliegenden Erfindung

Fig. 3 eine Darstellung verschiedener Spannungen an einem Akkumulator

Fig. 4 ein idealisierter Spannungsverlauf zweier Spannungsverläufe beim erfindungsgemäßen Verfahren

Fig. 5 eine Anordnung mit erster und zweiter Menge

Fig. 6 eine Anordnung mit galvanisch getrenntem Spannungswandler

Fig. 7 eine detailliertere Darstellung einer erfindungsgemäßen Vorrichtung mit Akkumulator

Fig. 8 eine Darstellung der Ansteuerung zweier Schalter eines Gleichrichters aus Fig. 7

Fig. 9 Eine Darstellung mehrerer Spannungswandler mit einem gemeinsamen Filter zur Erzeugung von phasenverschobenen Stromanteilen

Fig. 10 Eine Darstellung mehrerer Spannungswandler mit jeweils einem dedizierten Filter zur Erzeugung von phasenverschobenen Stromanteilen

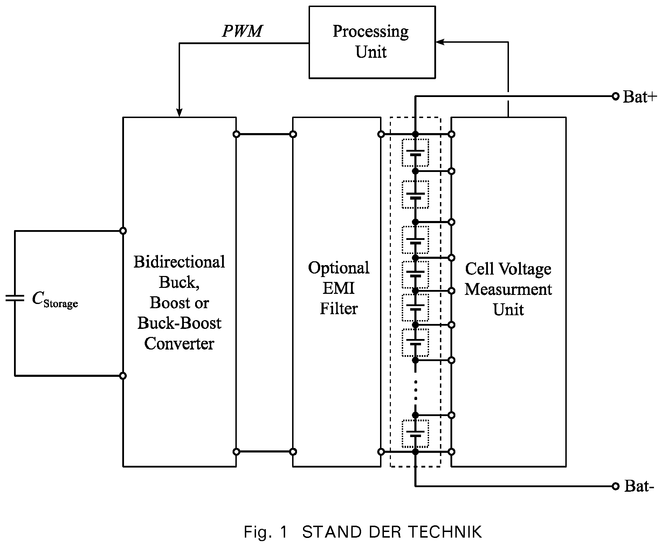

Fig. 1 zeigt eine Anordnung aus einer erst Menge Akkumulatorzellen, die in Reihe geschaltet sind. Zwischen jeder der Akkumulatorzellen und am Anfang und Ende der Reihenschaltung sind Senseleitungen angeordnet, die zu einer Spannungsmesseinheit führen. An das Ende und den Anfang der Reihenschaltung ist über einen optionalen Filter eine Einheit zur Erzeugung des Ladungstransfers, hier von der gesamten Anordnung der Akkumulatorzellen in einen Speicherkondensator und zurück. Des Weiteren ist im oberen Bereich eine Einheit zur Steuerung des Ladungstransfers angeordnet.

Es sei hier, zurückkommend auf die einleitende Darstellung des Standes der Technik, angemerkt, dass im Stand der Technik auch Anordnungen bekannt sind, die mit mindestens einem Spannungswandler pro Zellenpaar eine Ladungsverschiebung zwischen benachbarten Zellen durchführen und keinen Speicherkondensator aufweisen.

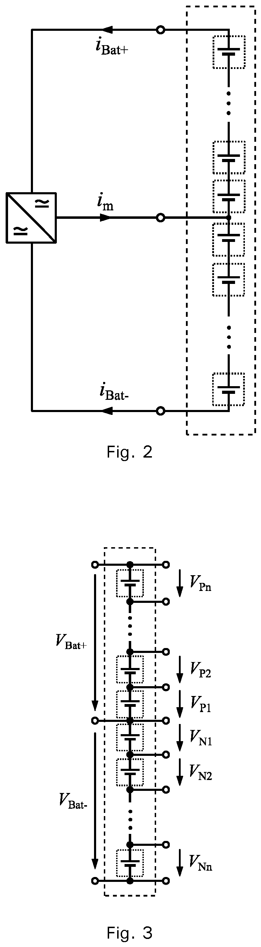

Fig. 2 zeigt eine Anordnung mit einem Akkumulator mit einer ersten Anzahl von Akkumulatorzellen und einer zweiten Anzahl von Akkumulatorzellen, die alle in Reihe geschaltet sind. Zwischen der ersten und der zweiten Anzahl ist eine Leitung für den Ladungstransfer angeordnet, der mittels des Spannungswandlers der zwei am Plus und Minuspol des Akkumulators angeordneten Leitungen erfolgt. Die Spannungsmessung ist hier im Sinne der Übersichtlichkeit nicht dargestellt. Dargestellt sind hingegen drei exemplarisch denkbare Orte für eine Messung des Ladungstransferstroms. Grundsätzlich würde es bei symmetrischer Aufteilung der Akkumulatorzellen der ersten Menge in erste und zweite Anzahl auch ausreichen $i_m$ zu messen. Es können aber auch alternativ und/oder zusammen $i_{Bat+}$ und/oder $i_{Bat-}$ bestimmt werden.

Fig. 3 veranschaulicht die in Fig. 2 ausgeblendete Spannungsmessung Der Akkumulator verfügt über eine Vielzahl von Anschlüssen für die Spannungsmessung (rechts im Bild) und drei Anschlüssen für den Ladungstransfer /linke Seite). Dargestellt sind die Einzelzellenspannungen der einzelnen Akkumulatorzellen der ersten Anzahl $V_{P1}$ bis $V_{Pn}$ und der zweiten Anzahl $V_{N1}$ bis $V_{Nn}$. Somit ist der Akkumulator geeignet für eine Vierpunktmessung an jeder der Akkumulatorzelle, indem mittel der Anschlüsse der linken Seite ein Ladungstransfer bewirkt und mittels der rechten Anschüsse Spannungsmessungen erfolgen. Auch kann die Gesamtspannung der ersten Anzahl Akkumulatorzellen $V_{Bat+}$ und der zweiten Anzahl von Akkumulatorzellen $V_{Bat-}$ gemessen werden.

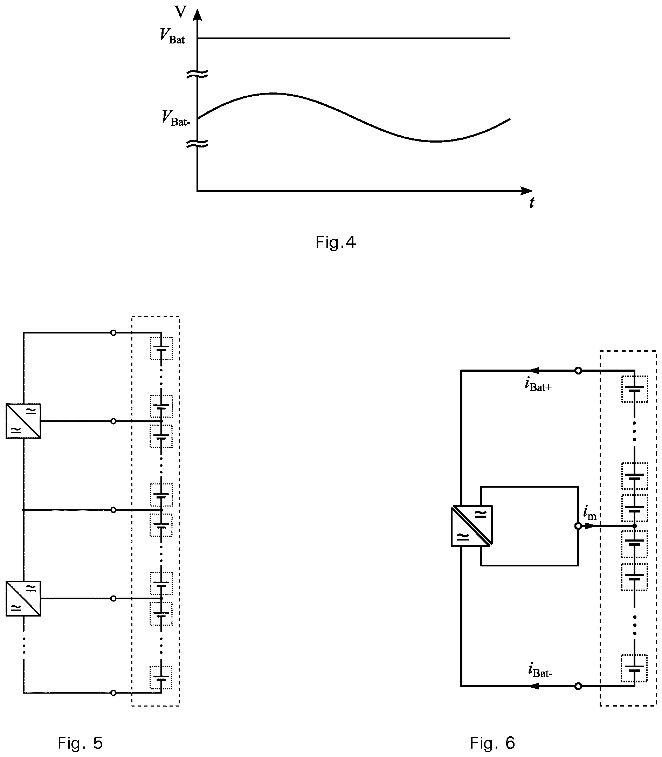

Fig. 4 zeigt unter Auslassung der Schaltartefakte des Spannungswandlers sich ergebende Spannungen. $V_{Bat}$ ist dabei die Gesamtspannung des Akkumulators. Zu erkennen ist, dass $V_{Bat-}$ von der hier nur ein einziger Sinusanteil gezeigt ist und sinusförmig schwankt, $V_{Bat}$ jedoch beinahe konstant bleibt.

Fig. 5 zeigt eine Anordnung mit einer ersten Menge, zwischen den obersten drei horizontalen Leitungen angeordnet und einer zweiten Menge, zwischen den unteren drei horizontalen Leitungen angeordnet. Jeder Menge ist ein Spannungswandler zugeordnet. Die Punkte im Akkumulator sollen andeuten, das hier noch mehrere nicht gezeigte Zellen in Reihe angeordnet sind. Die Punkte unten links sollen andeuten, dass darüber hinaus noch weitere Mengen folgen können, wobei die unterste Akkumulatorzelle immer zu der untersten Menge gehört.

Fig. 6 zeigt eine Anordnung wie in Fig. 2, jedoch mit galvanischer Trennung.

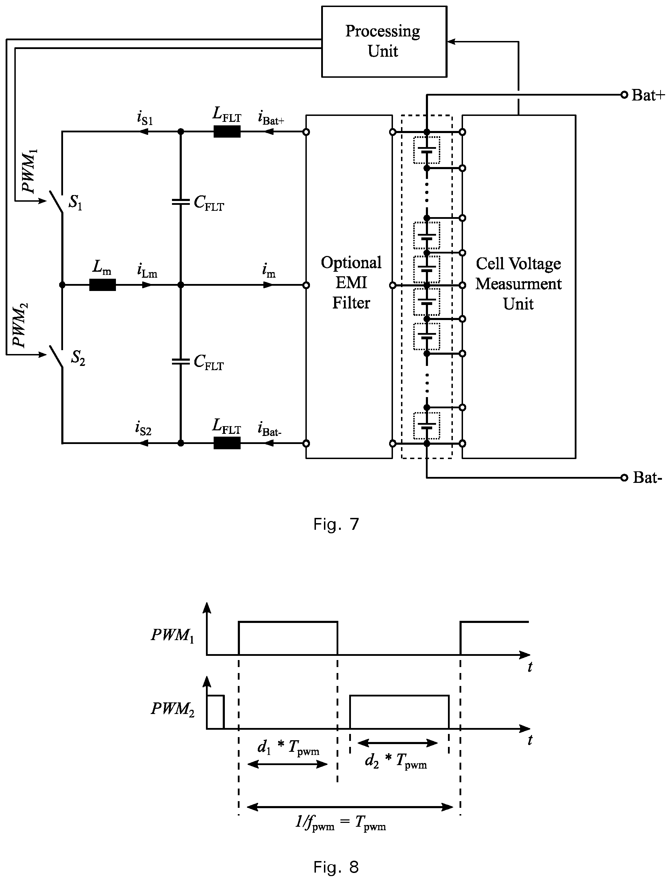

Fig. 7 zeigt eine detailliertere Darstellung einer erfindungsgemäßen Anordnung in Anlehnung an die Anordnung aus dem Stand der Technik der Fig. 1. Zu erkennen ist ein im Detail dargestellter Spannungswandler mit zwei Schaltern $S_1$ und $S_2$ sowie Kapazitäten und Induktivitäten. Dieser ist mittels einen optionalen, also auch wegdenkbaren, Filters an drei Anschlüsse eines Akkumulators angeschlossen, und zwar am Pluspol, am Minuspol und einmal zwischen den in Reihe geschalteten Zellen. Die Schalter S1 und S2 werden mittels PWM durch die Schaltsignale PWM1 und PWM2 angesteuert, die in einer Steuer- und Recheneinheit erzeugt werden. Auf der rechten Seite ist schematisch die Einzelspannungsmesseinheit zur Messung aller Einzelspannungen der Akkumulatorzellen dargestellt.

Fig. 8 veranschaulicht die Schaltsignale PWM1 und PWM2 aus Fig. 7. Zu erkennen sind die Tastdauern $d_1$ * Tpwm und $d_2$ * $T_{pwm}$ sowie die Tastgrade $d_1$ und $d_2$ der Schalter $S_1$ und $S_2$ wie die zwischen den Tastdauern liegenden Totzeiten.

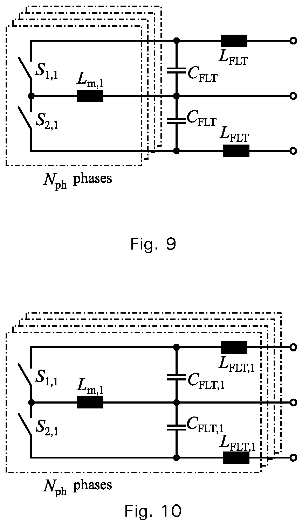

Fig. 9 zeigt eine Parallelschaltung mehrerer Spannungswandler, die einen gemeinsamen Filter nutzen, über den sie mit Akkumulatorzellen verbunden werden. Eine solche Anordnung kann beispielsweise den einzelnen Spannungswandler und den Filter aus Fig. 7 ersetzen. Insbesondere werden die Schalter der einzelnen Spannungswandler so angesteuert, dass sie, insbesondere näherungsweise (Abweichungen ergeben sich insbesondere durch die nicht zeitsynchrone Ansteuerung durch die entsprechenden Regler), denselben Stromverlauf, jedoch phasenversetzt zueinander erzeugen. Zusätzlich oder alternativ kann auch eine Parallelschaltung von Spannungswandlern eingesetzt werden, die jeweils einen eigenen Filter aufweisen. Dies ist in Figur 10 gezeigt. Zusätzlich oder alternativ kann auch eine Parallelschaltung von Spannungswandlern eingesetzt werden, die jeweils einen anderen Stromverlauf, insbesondere unterschiedliche Frequenzanteile erzeugen. Auch kann ein einziger Spannungswandler, sofern er denn schnell genug geschaltet werden kann genutzt werden unterschiedliche Signalanteile, beispielsweise phasenversetzt und/oder mit unterschiedlichen Frequenzen zu erzeugen.

**Patentansprüche**

1. Verfahren zur Bestimmung mindestens eines Impedanzwertes, insbesondere einer Vielzahl von Impedanzwerten, mindestens einer Akkumulatorzelle einer ersten Menge von Akkumulatorzellen, wobei die ersten Menge von Akkumulatorzellen durch eine erste Anzahl von Akkumulatorzellen und eine zweite Anzahl von Akkumulatorzellen gebildet wird, wobei mindestens ein Spannungswert, insbesondere mindestens eine Spannung und/oder Spannungsveränderung, mindestens einer der Akkumulatorzellen der ersten und/oder der zweiten Anzahl bestimmt wird, wobei die Akkumulatorzellen der ersten Anzahl in Reihe mit den Akkumulatorzellen der zweiten Anzahl geschaltet sind und wobei die erste und die zweite Anzahl jeweils mindestens zwei beträgt und wobei die erste Anzahl Akkumulatorzellen mindestens zwei in Reihe geschaltete Akkumulatorzellen aufweist und wobei die zweite Anzahl Akkumulatorzellen mindestens zwei in Reihe geschaltete Akkumulatorzellen aufweist, **dadurch gekennzeichnet, dass** während der Bestimmung des mindestens einen Spannungswertes, insbesondere periodisch, Ladung zwischen der ersten Anzahl von Akkumulatorzellen und der zweiten Anzahl von Akkumulatorzellen hin und her transferiert wird.

2. Verfahren nach Anspruch 1, wobei die Akkumulatorzellen der ersten Anzahl, insbesondere unmittelbar aufeinander folgend, in Reihe geschaltet sind und/oder wobei die Akkumulatorzellen der zweiten Anzahl, insbesondere unmittelbar aufeinander folgend, in Reihe geschaltet sind und/oder wobei die Akkumulatorzellen der ersten Anzahl, insbesondere unmittelbar aufeinander folgend, in Reihe mit den Akkumulatorzellen der zweiten Anzahl geschaltet sind und/oder wobei die Akkumulatorzellen der ersten Menge in Reihe geschaltet sind.

3. Verfahren nach einem der vorstehenden Ansprüche, wobei die Ladung und Entladung mittels mindestens einem DC/DC-Wandler, insbesondere galvanisch gekoppelte oder galvanisch getrennt, durchgeführt wird.

4. Verfahren nach einem der vorstehenden Ansprüche, wobei die Akkumulatorzellen der ersten Menge Akkumulatorzellen eines einzigen Akkumulators sind und wobei der Akkumulator insbesondere keine weiteren Akkumulatorzellen aufweist.

5. Verfahren nach einem der vorstehenden Ansprüche, wobei der Ladungstransfer, insbesondere periodisch, bewirkt und reversiert wird, insbesondere mit mindestens einer Frequenz, insbesondere im Bereich zwischen 0,1 und 10 kHz und/oder mit mindestens einer Frequenz von 1kHz oder weniger, wobei die Frequenzanteile unter 1kHz einen Ladungstransfer-Gesamtstrom von mindestens 0,1 A aufweisen, insbesondere bei Nenngesamtspannung der Akkumulatorzellen der ersten Menge von 12V und weniger und/der einer ersten Menge von weniger als 20 Akkumulatorzellen, und/oder, insbesondere bei einer Nenngesamtspannung der Akkumulatorzellen der ersten Menge von mehr als 12V und/der einer ersten Menge von mehr als 20 Akkumulatorzellen von mindestens 1A, bevorzugt mindestens 2 A, besonders bevorzugt von mindestens 3 A.

6. Verfahren nach einem der vorstehenden Ansprüche, wobei der Ladungstransfer und der reversierte Ladungstransfer so durchgeführt werden, dass im Zeitmittel über Vielfache der Periode der kleinsten enthaltenen Frequenz keine Nettoladungsverschiebung zwischen der ersten Menge Akkumulatorzellen und zweiten Menge Akkumulatorzellen stattfindet.

7. Verfahren nach einem der vorstehenden Ansprüche, wobei der Ladungstransfer so durchgeführt wird, dass die Gesamtspannung der ersten Menge, der Mengen und/oder des Akkumulators, insbesondere bei Betrachtung über einen Zeitraum des einfachen bis zehnfachen der längsten Periode des Anregungssignals oder des Ladungstransferstroms und/oder unter Rausrechnen der Verlustleistung des Ladungstransfers, weniger als 2% schwankt, wobei insbesondere die Amplitude der Spannungsschwankung mindestens einer der Akkumulatorzellen der ersten Menge mindestens 1mV beträgt und/oder wobei der Ladungstransfer und der reversierte Ladungstransfer und/oder die Bestimmung der mindesten einen Spannungswert während des Ladens oder Entladens, insbesondere zur Nutzung der Energie, des Akkumulators, insbesondere aller seiner Akkumulatorzellen, erfolgt.

8. Verfahren nach einem der vorstehenden Ansprüche, die, insbesondere durch den Ladungstransfer bewirkte und/oder periodisch und/oder durch das Verfahren, in einem Energiespeicher außerhalb des Akkumulators und/oder der Akkumulatorzellen der ersten Menge und/oder der ersten Menge und den weiteren Mengen, insbesondere in einen Kondensator, gespeicherte Energiemenge geringer gehalten wird als

$$\frac{\hat{\imath}_f \cdot (U_{\text{Leerlauf}} + \hat{u}_f)}{2 \cdot f_{\min}},$$

wobei $\hat{\imath}_f$ die maximale Amplitude des Anregungssignals oder des Ladungstransferstroms, $U_{\text{Leerlauf}}$ die Nenngesamt- oder Leerlaufgesamtspannung der ersten Menge von Akkumulatorzellen und $\hat{u}_f$ die maximale Amplitude der Summe der Einzelspannungsantwort der ersten Menge von Akkumulatorzellen ist.

9. Vorrichtung zur Durchführung mindestens einer Impedanzmessung, insbesondere elektrochemischen Impedanzspektroskopie, eingerichtet zur Bestimmung mindestens eines Impedanzwertes, insbesondere einer Vielzahl von Impedanzwerten, mindestens einer Akkumulatorzelle einer ersten Menge von Akkumulatorzellen, wobei die ersten Menge von Akkumulatorzellen durch eine erste Anzahl von Akkumulatorzellen und eine zweite Menge von Akkumulatorzellen gebildet wird, wobei die Vorrichtung eingerichtet ist, mindestens einen Spannungswert, insbesondere mindestsens eine Spannung und/oder Spannungsveränderung, mindestens einer der Ackumulatorzellen der ersten und/oder der zweiten Anzahl zu bestimmen, wobei die Akkumulatorzellen der ersten Anzahl in Reihe mit den Akkumulatorzellen der zweiten Anzahl geschaltet sind und wobei die erste und die zweite Anzahl jeweils mindestens zwei beträgt und wobei die erste Anzahl Akkumulatorzellen mindestens zwei in Reihe geschaltete Akkumulatorzellen aufweist und wobei die zweite Anzahl Akkumulatorzellen mindestens zwei in Reihe geschaltete Akkumulatorzellen aufweist, **dadurch gekennzeichnet, dass** die Vorrichtung eingerichtet ist während der Bestimmung des mindestens einen Spannungswertetes, insbesondere periodisch, Ladung zwischen der ersten Anzahl von Akkumulatorzellen und der zweiten Anzahl von Akkumulatorzellen hin und her zu transferieren.

10. Vorrichtung nach Anspruch 9, aufweisend eine Steuervorrichtung eingerichtet zur Durchführung eines Verfahrens nach einem der Ansprüche 1 bis 8 mittels der Vorrichtung.

11. Vorrichtung nach einem der Ansprüche 9 bis 10, wobei die Vorrichtung eingerichtet ist, Energie, insbesondere zur Filterung, insbesondere ausgehend von der Gesamtspannung der ersten Menge und/oder ersten und/oder zweiten Anzahl von Akkumulatorzellen, nur

für maximal 1/10 der Periode der niedrigsten Frequenz des Ladungstransfers und/oder Anregungssignal, für die die Vorrichtung eingerichtet ist, und/oder
für maximal das zehn-fache der größten Schließzeit eines für den Ladungstransfer genutzten Schaltelements, die in der Vorrichtung vorgesehen ist,
in der Vorrichtung und/oder außerhalb der ersten Menge von Akkumulatorzellen und/oder des Akkumulators eines Spannungswandlers zwischen zu speichern und/oder
wobei die Vorrichtung, insbesondere zum Zwischenspeichern von Energie, insbesondere aus einer Messung, nur Energiespeicher, insbesondere Kondensatoren ($C_{FLT}$, $C_{FLT,1}$) und Spulen ($L_{FLT}$, $L_{FLT,1}$), aufweist, die in der Summe nicht mehr Energie speichern können als

$$\frac{u_{max} \cdot i_{max}}{4 \cdot f_{min}},$$

wobei $u_{max}$ die maximale Akkumulatorspannung oder maximale Gesamtspannung der Akkumulatorzellen der ersten Menge ist, für die die Vorrichtung eingerichtet ist und $i_{max}$ die maximale Ladungstransferstromstärke ist, für die die Vorrichtung eingerichtet ist und $f_{min}$ die minimale Ladungstransferfrequenz oder der minimale Frequenzanteil im Ladungstransferstrom ist, für die die Vorrichtung eingerichtet ist.

12. Ladegerät für einen Akkumulator mit einer ersten Menge Akkumulatorzellen, wobei das Ladegerät eine Vorrichtung nach einem der Ansprüche 9 bis 11 aufweist und eingerichtet ist, insbesondere während der Ladung des Akkumulators den mindestens einen Impedanzwert zu bestimmen.

13. Batteriemanagementsystem, insbesondere eingerichtet zum Entladen, insbesondere zur Nutzung der Energie der Entladung, und/oder Laden eines Akkumulators mit einer ersten Menge Akkumulatorzellen, wobei das Batteriemanagementsystem eine Vorrichtung nach einem der Ansprüche 9 bis 11 aufweist und insbesondere eingerichtet ist, den mindestens einen Spannungswert während des Ladens und/oder Entladens des Akkumulators mittels der Akkumulatorsteuerung zu bestimmen.

14. Akkumulator aufweisend eine erste Menge Akkumulatorzellen und mindestens eine Batteriemanagementsystem nach Anspruch 13.

**Claims**

1. A method for determining at least one impedance value, in particular a lurality of impedance values, of at least one accumulator cell of a first set of accumulator cells, wherein the first set of accumulator cells is formed by a first number of accumulator cells and a second number of accumulator cells, wherein at least one voltage value, in particular at least one voltage and/or voltage change, of at least one of the accumulator cells of the first and/or the second number is determined, the accumulator cells of the first number being connected in series with the accumulator cells of the second number, and the first and the second number each being at least two, and the first number of accumulator cells having at least two series-connected accumulator cells, and the second number of accumulator cells having at least two series-connected accumulator cells, **characterised in that**, during the determination of said at least one voltage value, charge is transferred back and forth, in particular periodically, between the first number of accumulator cells and the second number of accumulator cells.

2. A method according to claim 1, wherein the accumulator cells of the first quantity are connected in series, in particular in direct succession, and/or wherein the accumulator cells of the second quantity are connected in series, in particular in direct succession, and/or wherein the accumulator cells of the first quantity are connected in series with the accumulator cells of the second quantity, in particular in direct succession, and/or wherein the accumulator cells of the first quantity are connected in series.

3. A method according to one of the preceding claims, wherein the charging and discharging is carried out by means of at least one DC/DC converter, in particular galvanically coupled or galvanically separated.

4. A method according to any one of the preceding claims, wherein the accumulator cells of the first set are accumulator cells of a single accumulator and wherein the accumulator in particular comprises no further accumulator cells.

5. A method according to one of the preceding claims, wherein the load transfer is effected and reversed, in particular periodically, in particular with at least one frequency, in particular in the range between 0.1 and 10 kHz and/or with at least one frequency of 1 kHz or less, wherein the frequency components below 1 kHz have a total load transfer current of at least 0.1 A, in particular with a nominal total voltage of the accumulator cells of the first set of 12V and less and/or a first set of less than 20 accumulator cells, and/or, in particular with a nominal total voltage of the accumulator cells of the first set of more than 12V and/or a first set of more than 20 accumulator cells of at least 1A, preferably at least 2 A, particularly preferably of at least 3 A.

6. A method according to any one of the preceding claims, wherein the load transfer and the reversed load transfer are performed such that there is no net charge shift between the first set of accumulator cells and second set of accumulator cells on a time average over multiples of the period of the smallest contained frequency.

7. A method according to any one of the preceding claims, wherein the load transfer is performed such that the total voltage of the first set, the sets and/or the accumulator varies less than 2%, in particular when considered over a period of time of one to ten times the longest period of the excitation signal or of the load transfer current and/or by calculating out the power loss of the load transfer, in particular the amplitude of the voltage variation of at least one of the accumulator cells of the first set being at least 1 mV and/or the load transfer and the reversed load transfer and/or the determination of said at least one voltage value being carried out during the charging or discharging, in particular for the use of the energy, of the accumulator, in particular of all its accumulator cells.

8. A method according to any one of the preceding claims, the amount of energy stored, in particular caused by the load transfer and/or periodically and/or by the method, in an energy store outside the accumulator and/or the accumulator cells of the first quantity and/or the first quantity and the further quantities, in particular in a capacitor, is kept lower than

$$\frac{\hat{\imath}_f \cdot (U_{\text{Leerlauf}} + \hat{u}_f)}{2 \cdot f_{\text{min}}},$$

Leerlauf = idle running
where ff is the maximum amplitude of the excitation signal or load transfer current, t/teeriauf is the nominal total or no-load total voltage of the first set of accumulator cells, and üf is the maximum amplitude of the sum of the individual voltage responses of the first set of accumulator cells.

9. A device for carrying out at least one impedance measurement, in particular electrochemical impedance spectroscopy, set up for determining at least one impedance value, in particular a plurality of impedance values, of at least one accumulator cell of a first set of accumulator cells, the first set of accumulator cells being formed by a first number of accumulator cells and a second set of accumulator cells, the device being set up for determining at least one voltage value, in particular at least one voltage and/or voltage change, of at least one of the accumulator cells of the first set and/or of the second set, the accumulator cells of the first number being connected in series with the accumulator cells of the second number and the first and the second number each being at least two and the first number of accumulator cells having at least two series-connected accumulator cells and the second number of accumulator cells having at least two series-connected accumulator cells, **characterized in that** the device is set up to transfer charge back and forth between the first number of accumulator cells and the second number of accumulator cells, in particular periodically, during the determination of said at least one voltage value.

10. A device according to claim 9, comprising a control device adapted to perform a method according to any one of claims 1 to 8 by means of the apparatus.

11. A device according to any one of claims 9 to 10, wherein the device is arranged to filter energy, in particular for filtering, in particular starting from the total voltage of the first quantity and/or first and/or second number of accumulator cells,

only for a maximum of 1/10 of the period of the lowest frequency of load transfer and/or excitation signal for which the device is set up, and/or

for a maximum of ten times the maximum closing time of a switching element used for load transfer provided in the device,
to store in the device and/or outside the first set of accumulator cells and/or the accumulator of a voltage transformer between and/or
wherein the device, in particular for the intermediate storage of energy, in particular from a measurement, has only energy stores, in particular capacitors (CFLT ,$C_{FLT1}$ ) and coils (LFLT ,$L_{FLT1}$ ), which in total cannot store more energy than

$$\frac{u_{\max} \cdot i_{\max}}{4 \cdot f_{\min}},$$

where **Umax** is the maximum accumulator voltage or maximum total voltage of the accumulator cells of the first set for which the device is arranged and imax is the maximum load transfer current strength for which the device is arranged and fmin is the minimum load transfer frequency or the minimum frequency component in the load transfer current for which the device is arranged.

12. A charger for an accumulator comprising a first set of accumulator cells, the charger comprising a device according to any one of claims 9 to 11 and being arranged to determine said at least one impedance value in particular during charging of the accumulator.

13. A battery management system, in particular arranged for discharging, in particular for utilising the energy of the discharge, and/or charging an accumulator with a first set of accumulator cells, wherein the bat tery management system comprises a device according to one of claims 9 to 11 and is in particular arranged to determine said at least one voltage value during charging and/or discharging of the accumulator by means of the accumulator control.

14. An accumulator comprising a first set of accumulator cells and at least one battery management system according to claim 13.

**Revendications**

1. Procédé pour déterminer au moins une valeur d'impédance, en particulier une pluralité de valeurs d'impédance, d'au moins une cellule d'accumulateur d'un premier jeu de cellules d'accumulateur, le premier jeu de cellules d'accumulateur étant constitué d'un premier nombre de cellules d'accumulateur et d'un second nombre de cellules d'accumulateur, dans lequel on détermine au moins une valeur de tension, en particulier au moins une variation de tension et/ou de tension, d'au moins une des cellules d'accumulateur du premier et/ou du second nombre, les cellules d'accumulateur du premier nombre étant montées en série avec les cellules d'accumulateur du second nombre, et le premier et le second nombre étant chacun au moins deux, et le premier nombre de cellules d'accumulateur comprenant au moins deux cellules d'accumulateur connectées en série, et le second nombre de cellules d'accumulateur comprenant au moins deux cellules d'accumulateur connectées en série, **caractérisé en ce que**, pendant la détermination de ladite au moins une valeur de tension, une charge est transférée en va-et-vient, en particulier périodiquement, entre le premier nombre de cellules d'accumulateur et le second nombre de cellules d'accumulateur.

2. Procédé selon la revendication 1, dans lequel les cellules d'accumulateur de la première quantité sont connectées en série, en particulier en succession directe, et/ou dans lequel les cellules d'accumulateur de la seconde quantité sont connectées en série, en particulier en succession directe, et/ou dans lequel les cellules d'accumulateur de la première quantité sont connectées en série avec les cellules d'accumulateur de la seconde quantité, en particulier en succession directe, et/ou dans lequel les cellules d'accumulateur de la première quantité sont connectées en série.

3. Procédé selon l'une des revendications précédentes, dans lequel la charge et la décharge sont réalisées au moyen d'au moins un convertisseur CC/CC, notamment à couplage galvanique ou à séparation galvanique.

4. Procédé selon l'une quelconque des revendications précédentes, dans lequel les cellules d'accumulateur du premier ensemble sont des cellules d'accumulateur d'un seul accumulateur et dans lequel l'accumulateur en particulier ne comprend pas d'autres cellules d'accumulateur.

**5.** Procédé selon l'une des revendications précédentes, dans lequel le transfert de charge est effectué et inversé, en particulier périodiquement, en particulier avec au moins une fréquence, en particulier dans la plage entre 0,1 et 10 kHz et/ou avec au moins une fréquence de 1 kHz ou moins, les composantes de fréquence inférieures à 1 kHz ayant un courant de transfert de charge total d'au moins 0.1 A, en particulier avec une tension nominale totale des cellules d'accumulateur du premier ensemble de 12 V et moins et/ou un premier ensemble de moins de 20 cellules d'accumulateur, et/ou, en particulier avec une tension nominale totale des cellules d'accumulateur du premier ensemble de plus de 12 V et/ou un premier ensemble de plus de 20 cellules d'accumulateur d'au moins 1 A, de préférence d'au moins 2 A, particulièrement préférablement d'au moins 3 A.

**6.** Procédé selon l'une quelconque des revendications précédentes, dans lequel le transfert de charge et le transfert de charge inversé sont réalisés de telle sorte qu'il n'y ait pas de déplacement de charge net entre le premier ensemble de cellules d'accumulateur et le second ensemble de cellules d'accumulateur sur une moyenne temporelle sur des multiples de la période de la plus petite fréquence contenue.

**7.** Procédé selon l'une quelconque des revendications précédentes, dans lequel le transfert de charge est réalisé de telle sorte que la tension totale du premier ensemble, des ensembles et/ou de l'accumulateur varie de moins de 2%, notamment en considérant une période de temps d'une à dix fois la plus longue période du signal d'excitation ou du courant de transfert de charge et/ou en calculant la perte de puissance du transfert de charge, notamment l'amplitude de la variation de tension d'au moins une des cellules de l'accumulateur du premier ensemble étant d'au moins 1 mV et/ou le transfert de charge et le transfert de charge inversé et/ou la détermination de ladite au moins une valeur de tension étant effectuée pendant la charge ou la décharge, notamment pour l'utilisation de l'énergie, de l'accumulateur, notamment de toutes ses cellules d'accumulateur.

**8.** Procédé selon l'une quelconque des revendications précédentes, la quantité d'énergie stockée, notamment du fait du transfert de charge et/ou périodiquement et/ou par le procédé, dans un accumulateur d'énergie en dehors de l'accumulateur et/ou des cellules d'accumulateur de la première quantité et/ou de la première quantité et des autres quantités, notamment dans un condensateur, est maintenue inférieure à

$$\frac{\hat{\imath}_f \cdot (U_{\text{Leerlauf}} + \hat{u}_f)}{2 \cdot f_{\min}},$$

Leerlauf = marche au ralenti
où $\hat{\imath}_f$ est l'amplitude maximale du signal d'excitation ou du courant de transfert de charge, $U_{\text{Leerlauf}}$ est la tension nominale totale ou totale à vide du premier ensemble de cellules d'accumulateur, et $\hat{u}_f$ est l'amplitude maximale de la somme des réponses de tension individuelles du premier ensemble de cellules d'accumulateur.

**9.** Dispositif pour effectuer au moins une mesure d'impédance, en particulier une spectroscopie d'impédance électrochimique, configuré pour déterminer au moins une valeur d'impédance, en particulier une pluralité de valeurs d'impédance, d'au moins une cellule d'accumulateur d'un premier ensemble de cellules d'accumulateur, le premier ensemble de cellules d'accumulateur étant formé d'un premier nombre de cellules d'accumulateur et d'un second ensemble de cellules d'accumulateur, le dispositif étant conçu pour déterminer au moins une valeur de tension, en particulier au moins une tension et/ou une variation de tension, d'au moins une des cellules d'accumulateur du premier ensemble et/ou du second ensemble, les cellules d'accumulateur du premier nombre étant connectées en série avec les cellules d'accumulateur du second nombre et le premier et le second nombre étant chacun au moins deux et le premier nombre de cellules d'accumulateur ayant au moins deux cellules d'accumulateur connectées en série et le second nombre de cellules d'accumulateur ayant au moins deux cellules d'accumulateur connectées en série, **caractérisé en ce que** le dispositif est configuré pour transférer la charge en va-et-vient entre le premier nombre de cellules d'accumulateur et le second nombre de cellules d'accumulateur, en particulier périodiquement, pendant la détermination de ladite au moins une valeur de tension.

**10.** Dispositif selon la revendication 9, comprenant un dispositif de commande adapté pour exécuter un procédé selon l'une quelconque des revendications 1 à 8 au moyen de l'appareil.

**11.** Dispositif selon l'une quelconque des revendications 9 à 10, dans lequel le dispositif est agencé pour filtrer l'énergie, notamment pour filtrer, en particulier à partir de la tension totale de la première quantité et/ou du premier et/ou du second nombre de cellules d'accumulateur,

seulement pendant un maximum de 1/10 de la période de la plus basse fréquence du signal de transfert de charge et/ou d'excitation pour laquelle le dispositif est réglé, et/ou

pour un maximum de dix fois le temps de fermeture maximal d'un élément de commutation utilisé pour le transfert de charge prévu dans le dispositif,

de stocker dans le dispositif et/ou à l'extérieur le premier ensemble de cellules d'accumulateur et/ou l'accumulateur d'un transformateur de tension entre et/ou

dans lequel le dispositif, en particulier pour le stockage intermédiaire d'énergie, notamment à partir d'une mesure, ne comporte que des accumulateurs d'énergie, notamment des condensateurs (CFLT ,$C_{FLT1}$ ) et des bobines (LFLT ,$L_{FLT1}$ ), qui au total ne peuvent pas stocker plus d'énergie que

$$\frac{u_{max} \cdot i_{max}}{4 \cdot f_{min}},$$

où **Umax** est la tension maximale de l'accumulateur ou la tension totale maximale des cellules de l'accumulateur du premier ensemble pour lequel le dispositif est agencé et imax est l'intensité maximale du courant de transfert de charge pour lequel le dispositif est agencé et fmin est la fréquence minimale de transfert de charge ou la composante de fréquence minimale dans le courant de transfert de charge pour lequel le dispositif est agencé.

12. Chargeur pour un accumulateur comprenant un premier ensemble de cellules d'accumulateur, le chargeur comprenant un dispositif selon l'une quelconque des revendications 9 à 11 et étant agencé pour déterminer ladite au moins une valeur d'impédance notamment lors de la charge de l'accumulateur.

13. Système de gestion de batterie, en particulier agencé pour décharger, en particulier pour utiliser l'énergie de la décharge, et/ou charger un accumulateur avec un premier ensemble de cellules d'accumulateur, dans lequel le système de gestion de batterie comprend un dispositif selon l'une des revendications 9 à 11 et est en particulier agencé pour déterminer ladite au moins une valeur de tension pendant la charge et/ou la décharge de l'accumulateur au moyen de la commande d'accumulateur.

14. Accumulateur comprenant un premier ensemble de cellules d'accumulateur et au moins un système de gestion de batterie selon la revendication 13.

Fig. 1 STAND DER TECHNIK

Fig. 2

Fig. 3

Fig.4

Fig. 5

Fig. 6

Fig. 7

Fig. 8

Fig. 9

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2017163160 A1
- US 10393818 B2
- US 20190288520 A1
- US 2015145520 A1

**In der Beschreibung aufgeführte Nicht-Patentliteratur**

- **DIN.** A Scalable Active Battery Management System with Embedded Real-Time Electrochemical Impedance Spectroscopy. *IEEE Transactions on Power Electronics*